Europäisches Patentamt

European Patent Office

Office européen des brevets

(11) Veröffentlichungsnummer: **0 211 357 B1**

(19)

(12) **EUROPÄISCHE PATENTSCHRIFT**

(45) Veröffentlichungstag der Patentschrift: **24.06.92**

(21) Anmeldenummer: **86110306.7**

(22) Anmeldetag: **25.07.86**

(51) Int. Cl.5: **H01R 9/09**

(54) **Verfahren zur Herstellung einer Kontakteinrichtung auf einer Leiterplatte.**

(30) Priorität: **29.07.85 DE 3527142**

(43) Veröffentlichungstag der Anmeldung:
**25.02.87 Patentblatt 87/09**

(45) Bekanntmachung des Hinweises auf die
Patenterteilung:
**24.06.92 Patentblatt 92/26**

(84) Benannte Vertragsstaaten:
**DE GB SE**

(56) Entgegenhaltungen:
**DE-A- 3 329 650**
**GB-A- 970 005**
**US-A- 4 332 430**

(73) Patentinhaber: **SIEMENS AKTIENGESELL-
SCHAFT**
**Wittelsbacherplatz 2**
**W-8000 München 2(DE)**

(72) Erfinder: **Awakowicz, Erwin, Dipl.-Ing.**
**Richard-Pietzsch-Weg 18**
**W-8000 München 71(DE)**
Erfinder: **Kleine, Peter, Dipl.-Ing.**
**Kramerstrasse 9**
**W-8121 Fischen(DE)**

# Beschreibung

Die Erfindung betrifft ein Verfahren zur Herstellung einer auf der Bauteileseite einer Leiterplatte angeordneten, durch zumindest eine U-förmig gestaltete Steckaufnahme gebildeten Kontakteinrichtung für Steckeinrichtungen, wobei die freien Enden der außenliegenden Schenkel der Steckaufnahme als Lötanschlüsse ausgebildet sind, die Durchbrüche in der Leiterplatte durchgreifen und rückseitig mit Leiterbahnen elektrisch und mechanisch kontaktiert sind und wobei ferner zwischen den Schenkeln der Steckaufnahme ein in Richtung auf die Leiterplatte weisender Steckbereich angeordnet ist, der sich im Bereich einer Ausnehmung in der Leiterplatte befindet, die von den Gegenkontakten einer von der Lötseite einführbaren Steckeinrichtung durchgriffen wird.

Durch die GB-A-970 005 ist eine Kontakteinrichtung der eingangs geschilderten Art bekannt, bei der die äußeren Schenkel der U-förmigen Steckaufnahme in ihren äußeren Endbereichen einen der Leiterplattenstärke konturmäßig entsprechenden Einschnitt aufweisen, dessen Endbereiche eine Ausnehmung in der Leiterplatte durchgreifen und mit auf der Leiterplatte angeordneten Leiterbahnen kontaktiert und verlötet werden. Im Bereich der Ausnehmung der Leiterplatte befindet sich entweder ein aus zwei federnden Schenkeln bestehender Steckbereich oder nur ein federnder Schenkel, der mit einem der äußeren Schenkel der Steckaufnahme den Steckbereich bildet. In diesen so gebildeten Steckbereich wird durch die Ausnehmung in der Leiterplatte eine weitere Leiterplatte eingeschoben.

In der zitierten Entgegenhaltung kann dieser Steckbereich auch als Steckzunge gestaltet sein, auf die ein entsprechend gestaltetes Steckelement aufgebracht werden kann.

Da die Befestigung der Steckaufnahme sowie der weiteren auf der Leiterplatte aufgebrachten elektrischen Bauelemente üblicherweise im Schwallötverfahren erfolgt, besteht bei dieser Anordnung leicht die Gefahr, daß der Steckbereich wie auch die Steckzunge von dem durch die Ausnehmung in der Leiterplatte hindurchdringenden Lot benetzt und somit für das Aufbringen des die Gegenkontakte aufweisenden Steckelementes unbrauchbar gemacht wird.

Aufgabe der vorliegenden Erfindung ist es daher, ein Verfahren zur Herstellung einer Steckverbindung aufzuzeigen, durch das stets die volle Funktionsfähigkeit des Steckbereiches der Steckaufnahme gewährleistet wird.

Diese Aufgabe wird dadurch gelöst, daß die Ausnehmung in der Leiterplatte durch Herausstanzen eines Stanzteils gebildet wird, daß die Leiterplatte mit Bauteilen und der die Kontakteinrichtung bildenden Steckaufnahme bestückt wird, daß weiterhin das Stanzteil vor dem Lötvorgang in die Ausnehmung zurückgedrückt und nach dem Lötvorgang wieder entfernt wird.

Bei der Befestigung der Steckaufnahme im Schwallötverfahren wird nunmehr die Ausnehmung in der Leiterplatte durch das ihr formmäßig entsprechende Stanzteil abgedeckt, so daß das Lot nicht an den Steckbereich der Steckaufnahme gelangen kann. Dadurch kann in einfacher Weise ein gegebenenfalls erforderliches Nachbearbeiten des durch das Lot unbrauchbar gemachten Steckbereiches der Steckaufnahme bzw. ein notwendig gewordenes Entfernen und Wiederanbringen der gesamten Steckaufnahme vermieden werden.

Die Erfindung soll im folgenden anhand eines Ausführungsbeispiels näher erläutert werden.

Es zeigen

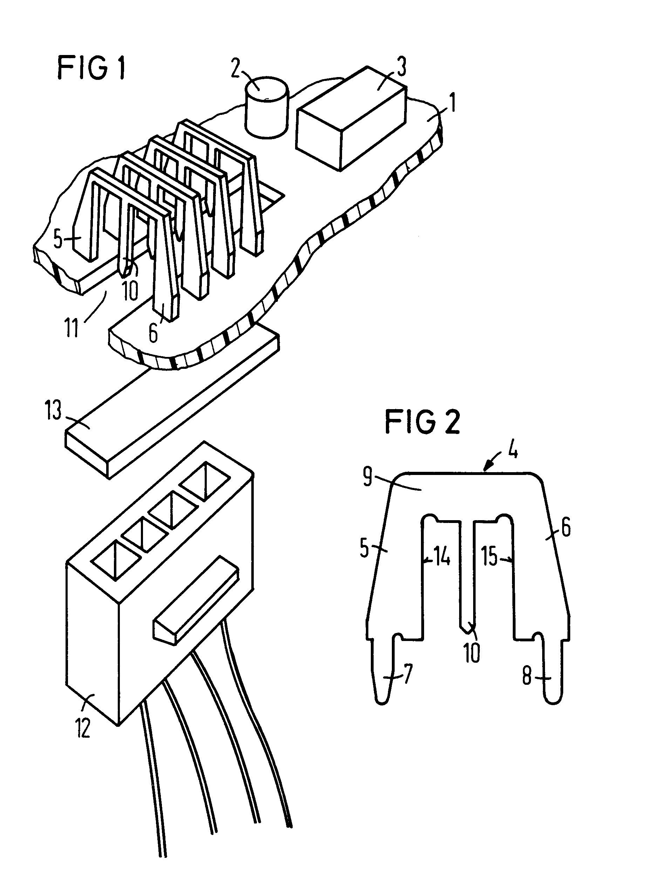

Fig. 1 in einer Explosionszeichnung die auf einer Leiterplatte befestigte Steckaufnahme und der dazugehörige Stecker,

Fig. 2 die Steckaufnahme in einer Seitenansicht.

Auf einer Leiterplatte 1, die unter anderem zur Aufnahme von elektrischen Bauteilen 2 und 3 dient, ist die Steckaufnahme 4 befestigt.

Die Steckaufnahme 4 ist U-förmig gestaltet, wobei ihre außenliegenden Schenkel 5 und 6 an ihren freien Enden Lötfahnen 7 und 8 besitzen, die die Leiterplatte durchgreifen und zur elektrischen Kontaktierung und zur Befestigung der Steckaufnahme auf der Leiterplatte 1 dienen.

Zwischen den Schenkeln 5 und 6 ist parallel zu ihnen und senkrecht zur Basis 9 verlaufend die Steckzunge 10 angeordnet. Die Steckzunge 10 weist in Richtung auf eine Ausnehmung 11 in der Leiterplatte 1. Die Ausnehmung 11 wird von dem Stecker 12 durchgriffen. Die sich gegenüberliegenden Innenseiten 14 und 15 der Schenkel 5 und 6 bilden dabei neben den Wänden der Ausnehmung 11 eine Führung für den Stecker 12. Die Steckzunge 10 ist dabei so dimensioniert, daß sie mit den im Stecker 12 angeordneten Gegenkontakten eine Kontaktverbindung eingeht. Je nach Anzahl der im Stecker vorhandenen Gegenkontakte sind eine entsprechende Anzahl von Steckaufnahmen 4 vorgesehen.

Bei der Befestigung der Steckaufnahme 4 im Schwallötverfahren wird die Ausnehmung 11 durch das ihr formmäßig entsprechende Stanzteil 13 abgedeckt, so daß das Lot nicht an die Steckzunge 10 gelangen kann. Nach dem Schwallöten wird dieses Stanzteil entfernt.

Bezugszeichenliste

| 1 | Leiterplatte |
| 2 | elektrisches Bauteil |
| 3 | elektrisches Bauteil |

4 Steckaufnahme
5 Schenkel
6 Schenkel
7 Lötfahnen
8 Lötfahnen
9 Basis
10 Steckzunge
11 Ausnehmung
12 Stecker
13 Stanzteil
14 Innenseite
15 Innenseite

**Patentansprüche**

1. Verfahren zur Herstellung einer auf der Bauteileseite einer Leiterplatte (1) angeordneten, durch zumindest eine U-förmig gestaltete Steckaufnahme (4) gebildeten Kontakteinrichtung für Steckeinrichtungen (12), wobei die freien Enden der außenliegenden Schenkel (5, 6) der Steckaufnahme (4) als Lötanschlüsse ausgebildet sind, die Durchbrüche in der Leiterplatte (1) durchgreifen und rückseitig mit Leiterbahnen elektrischen und mechanisch kontaktiert sind und wobei ferner zwischen den Schenkeln (5, 6) der Steckaufnahme (4) ein in Richtung auf die Leiterplatte (1) weisender Steckbereich (10) angeordnet ist, der sich im Bereich einer Ausnehmung (11) in der Leiterplatte (1) befindet, die von den Gegenkontakten einer von der Lötseite einführbaren Steckeinrichtung (12) durchgriffen wird, **dadurch gekennzeichnet,** daß die Ausnehmung (11) in der Leiterplatte (1) durch Herausstanzen eines Stanzteiles (13) gebildet wird, daß die Leiterplatte (1) mit Bauteilen (2, 3) und der die Kontakteinrichtung bildenden Steckaufnahme (4) bestückt wird, daß weiterhin das Stanzteil (13) vor dem Lötvorgang in die Ausnehmung (11) zurückgedrückt und nach dem Lötvorgang wieder entfernt wird.

**Claims**

1. Process for producing a contact device for plug devices (12), which is arranged on the component side of a printed-circuit board (1) and is formed by at least one plug holder (4) of U-shaped design, the free ends of the externally located limbs (5, 6) of the plug holder (4) being constructed as solder terminals which engage through holes in the printed-circuit board (1) and, on the rear side, make electrical and mechanical contact with conductor tracks and, furthermore, there being arranged between the limbs (5, 6) of the plug holder (4) a plug region (10) which points in the direction of the printed-circuit board (1) and is located in the region of a recess (11) in the printed-circuit board (1), through which recess (11) there engage mating contacts of a plug device (12) which can be inserted from the solder side, characterised in that the recess (11) in the printed-circuit board (1) is formed by stamping out a stamped part (13), in that the printed-circuit board (1) is fitted with components (2, 3) and the plug holder (4) forming the contact device, and in that, moreover, the stamped part (13) is pressed back into the recess (11) before the soldering process and is removed again after the soldering process.

**Revendications**

1. Procédé pour former un dispositif de contact disposé sur la face, qui porte les composants, d'une plaquette à circuits imprimés (1) et constitué par au moins une prise femelle (4) agencée en forme de U, pour des dispositifs à enfichage (12), et selon lequel les extrémités libres des branches extérieures (5,6) de la prise (4) sont réalisées sous la forme de cosses à souder, traversent les passages ménagés dans la plaquette à circuits imprimés (1) et établissent un contact électrique et mécanique sur la face arrière avec les voies conductrices, et selon lequel en outre entre les branches (5,6) de la prise (4) est disposée un élément d'enfichage (10), qui s'étend en direction de la plaquette à circuits imprimés (1) et est située au voisinage d'une ouverture (11) ménagée dans la plaquette à circuits imprimés (1), que traversent des contacts antagonistes d'un dispositif à enfichage (12) pouvant être inséré à partir de la face à souder, caractérisé par le fait qu'on forme l'ouverture (11) dans la plaquette à circuits imprimés (1) en en retirant par découpage une partie (13), qu'on équipe la plaquette à circuits imprimés (1) avec des composants (2,3) et avec la prise (4) constituant le dispositif de contact et qu on repousse en outre la partie découpée (13) dans l'ouverture (11), après l'opération de soudage et qu'on la retire à nouveau après l'opération de soudage.

FIG 1

FIG 2